# EUROPÄISCHE PATENTSCHRIFT

(11) **EP 4 286 867 B1**
(45) Veröffentlichungstag und Bekanntmachung des Hinweises auf die Patenterteilung: **28.01.2026**
(21) Anmeldenummer: 23174637.1
(22) Anmeldetag: 22.05.2023
(51) Int. Cl.: G01R 31/36, G01R 31/385

(54) **SCHALTVORRICHTUNG FÜR EINEN PRÜFSTAND FÜR ELEKTRISCHE KOMPONENTEN UND PRÜFSTAND FÜR ELEKTRISCHE KOMPONENTEN**
SWITCHING DEVICE FOR A TEST BENCH FOR ELECTRICAL COMPONENTS AND TEST BENCH FOR ELECTRICAL COMPONENTS
DISPOSITIF DE COMMUTATION POUR UN BANC D'ESSAI DE COMPOSANTS ÉLECTRIQUES ET BANC D'ESSAI DE COMPOSANTS ÉLECTRIQUES

(30) Priorität: 31.05.2022 DE 102022113770
(43) Veröffentlichungstag der Anmeldung: 06.12.2023
(73) Patentinhaber: Hahn Automation GmbH, 55494 Rheinböllen (DE)
(72) Erfinder: Sulzbacher, Martin, 55444 Dörrebach (DE); Justus, Andrej, 55469 Simmern (DE); Meißner, Thomas, 56291 Pfalzfeld (DE); Praetorius, Manuel, 55494 Rheinböllen (DE)
(74) Vertreter: Janke Scholl Patentanwälte PartG mbB

(56) Entgegenhaltungen:
- CN-A- 113 490 355
- CN-U- 212 540 654
- US-A1- 2019 273 289

## Beschreibung

Die vorliegende Erfindung betrifft eine Schaltvorrichtung für einen Prüfstand für elektrische Komponenten und einen Prüfstand für elektrische Komponenten.

Moderne Kraftfahrzeuge werden zunehmend mit vollständig elektromotorischem Antrieb oder Hybridantrieb ausgestattet. Dabei dient eine Batterie, die auch als Traktionsbatterie bezeichnet wird, zur Versorgung eines Elektromotors oder mehrerer Elektromotoren mit elektrischer Leistung, um das betreffende Fahrzeug mittels des Elektromotors oder mittels mehrerer Elektromotoren anzutreiben.

Während der Herstellung derartiger Batterien werden diese vielfältigen Tests unterzogen. Unter anderem findet eine Leistungsprüfung bzw. Funktionsprüfung der Batterie statt, die die Funktionstüchtigkeit und Funktionssicherheit im Rahmen einer End-of-Line Prüfung sicherstellt. Dabei wird eine betreffende zu prüfende Batterie in kurzer Zeit mehrfach geladen und wieder entladen. Weiter kann die Batterie einer Hochvoltspannung zur Isolationsprüfung ausgesetzt werden.

Zur Verbindung einer zu prüfenden Batterie mit einem Prüfstand für elektrische Komponenten sind eine Vielzahl von Steckverbindungen erforderlich. So können neben der Leistungsversorgung eine Vielzahl von Steuer- und Datenleitungen vorhanden sein, die alle separat verbunden werden müssen. So kann es vorkommen, dass mehr als vierzig Steckverbindungen zwischen der Batterie und dem Prüfstand für elektrische Komponenten hergestellt werden.

Während einer Leistungs- bzw. Funktionsprüfung der Batterie sind alle Anschlüsse der Batterie separat geschaltet. Im Rahmen der Hochvolt- bzw. Isolationsprüfung müssen jedoch die Anschlüsse gebrückt und dann wiederum einzeln geprüft bzw. beschaltet werden. Es besteht daher eine Herausforderung darin, zügig zwischen einer Leistungsprüfung und einer Isolationsprüfung wechseln zu können.

Die Begriffe Leistungsprüfung und Funktionsprüfung werden im vorliegenden Text synonym verwendet.

Während der Leistungsprüfung liegen die Spannungen in Bereichen von 5 Volt bis zu 1000 Volt an und die Ströme liegen in Bereichen von bis zu 1000 Ampere an. Während der Isolationsprüfung liegen Spannungen im Bereich von bis zu 10000 Volt bei Strömen im Bereich von wenigen Milliampere an. Es besteht daher eine Herausforderung darin, robuste Komponenten bereitzustellen, die voranstehenden elektrischen Leistungen zuverlässig und sicher übertragen, insbesondere bei gleichzeitig kompakter Bauweise.

Die Dokumente CN212540654U, CN113490355A und US2019273289A1 zeigen Einrichtung zur Prüfung von Batterien.

Vor diesem Hintergrund liegt der Erfindung die technische Problemstellung zugrunde, eine Schaltvorrichtung für einen Prüfstand für elektrische Komponenten und einen Prüfstand für elektrische Komponenten anzugeben, die einen einfachen, sicheren und schnellen Wechsel zwischen einer Funktionsprüfung und einer Isolationsprüfung ermöglichen, die dabei geforderten elektrischen Leistungen zuverlässig und sicher übertragen und insbesondere einen geringen Bauraum einnehmen.

Die voranstehend beschriebene, technische Problemstellung wird durch den unabhängigen Anspruch gelöst. Weitere Ausgestaltungen der Erfindung ergeben sich aus den abhängigen Ansprüchen und der nachstehenden Beschreibung. Gemäß einer ersten Alternative betrifft die Erfindung eine Schaltvorrichtung für einen Prüfstand für elektrische Komponenten, mit einer Tragstruktur, mit einem an der Tragstruktur befestigten ersten Kontaktblock, wobei der erste Kontaktblock erste Anschlüsse zum Anschließen einer zu prüfenden Batterie aufweist, wobei der erste Kontaktblock einen oder mehr zweite Anschlüsse zum Anschließen eines Hochvolt-Testers aufweist und wobei der erste Kontaktblock dritte Anschlüsse zum Anschließen eines Funktions-Testers aufweist, mit einem zweiten Kontaktblock, wobei der zweite Kontaktblock eine Kontaktbrücke ist, wobei der zweite Kontaktblock relativ zu dem ersten Kontaktblock bewegbar ist, wobei der zweite Kontaktblock in einer ersten Kontaktstellung die ersten Anschlüsse mit mindestens einem zweiten Anschluss verbindet, wobei die ersten Anschlüsse in der ersten Kontaktstellung mittels eines Brückenelements des ersten Kontaktblocks gebrückt und über das Brückenelement mit dem mindestens einen zweiten Anschluss verbunden sind, wobei der zweite Kontaktblock in einer zweiten Kontaktstellung die ersten Anschlüsse mit den dritten Anschlüssen verbindet.

Gemäß der voranstehend beschriebenen, ersten alternativen Bauart der erfindungsgemäßen Schaltvorrichtung werden die ersten Anschlüsse in der ersten Kontaktstellung gebrückt.

Gemäß einer zweiten Alternative betrifft die Erfindung eine Schaltvorrichtung für einen Prüfstand für elektrische Komponenten, mit einer Tragstruktur, mit einem an der Tragstruktur befestigten ersten Kontaktblock, wobei der erste Kontaktblock erste Anschlüsse zum Anschließen einer zu prüfenden Batterie aufweist, wobei der erste Kontaktblock einen oder mehr zweite Anschlüsse zum Anschließen eines Hochvolt-Testers aufweist und wobei der erste Kontaktblock dritte Anschlüsse zum Anschließen eines Funktions-Testers aufweist, mit einem zweiten Kontaktblock, wobei der zweite Kontaktblock eine Kontaktbrücke ist, wobei der zweite Kontaktblock relativ zu dem ersten Kontaktblock bewegbar ist, wobei der zweite Kontaktblock in einer ersten Kontaktstellung die ersten Anschlüsse mit den zweiten Anschlüssen verbindet, wobei der zweite Kontaktblock in einer zweiten Kontaktstellung die ersten Anschlüsse mit den dritten Anschlüssen verbindet.

Gemäß der voranstehend beschriebenen, zweiten alternativen Bauart der erfindungsgemäßen Schaltvorrichtung werden die ersten Anschlüsse in der ersten Kontaktstellung einzeln mit den zweiten Anschlüssen verbunden.

Es werden daher erfindungsgemäß zwei alternative Schaltvorrichtungen angegeben, wobei eine erste Bauart einer ersten erfindungsgemäßen Schaltvorrichtung derart ausgestaltet ist, dass der zweite Kontaktblock in einer ersten Kontaktstellung die ersten Anschlüsse mit mindestens einem zweiten Anschluss verbindet, wobei die ersten Anschlüsse in der ersten Kontaktstellung mittels eines Brückenelements des ersten Kontaktblocks gebrückt und über das Brückenelement mit dem mindestens einen zweiten Anschluss verbunden sind, und wobei eine zweite Bauart einer zweiten erfindungsgemäßen Schaltvorrichtung derart ausgestaltet ist, dass in einer ersten Kontaktstellung die ersten Anschlüsse mit den zweiten Anschlüssen verbunden sind.

Der zweite Kontaktblock ermöglicht daher in einfacher Weise ein schnelles Umschalten zwischen einer Funktionsprüfung mittels eines Funktions-Testers und einer Isolationsprüfung mittels eines Hochvolt-Testers.

Es kann vorgesehen sein, dass zwanzig oder mehr erste Anschlüsse und zwanzig oder mehr dritte Anschlüsse vorgesehen sind.

Alternativ oder ergänzend kann vorgesehen sein, dass einhundert oder weniger erste Anschlüsse und einhundert oder weniger dritte Anschlüsse vorgesehen sind.

Es kann vorgesehen sein, dass genau vierzig erste Anschlüsse und genau vierzig dritte Anschlüsse vorgesehen sind.

Eine hohe Anzahl an ersten und dritten Anschlüssen kann z.B. im Rahmen der Prüfung von Signalleitungen, wie BUS Leitungen, CAN-BUS Leitungen oder dergleichen, verwendet werden.

Gemäß einer Ausgestaltung der Schaltvorrichtung kann vorgesehen sein, dass die ersten Anschlüsse und die dritten Anschlüsse für einen Strom von maximal 32 Ampere (A) und/oder für eine Spannung von maximal 10 Kilovolt (kV) ausgelegt sind.

Es kann vorgesehen sein, dass zwei oder mehr erste Anschlüsse und zwei oder mehr dritte Anschlüsse vorgesehen sind.

Alternativ oder ergänzend kann vorgesehen sein, dass zehn oder weniger erste Anschlüsse und zehn oder weniger dritte Anschlüsse vorgesehen sind.

Es kann vorgesehen sein, dass genau drei erste Anschlüsse und genau drei dritte Anschlüsse vorgesehen sind.

Es kann vorgesehen sein, dass genau sechs erste Anschlüsse und genau sechs dritte Anschlüsse vorgesehen sind.

Gemäß einer Ausgestaltung der Schaltvorrichtung kann vorgesehen sein, dass die ersten Anschlüsse und die dritten Anschlüsse für einen Strom von maximal 1000 Ampere, insbesondere maximal 600 Ampere, und/oder für eine Spannung von maximal 10 Kilovolt ausgelegt sind.

Die ersten Anschlüsse können nebeneinander entlang einer Längsrichtung geradlinig aufgereiht sind. Die dritten Anschlüsse können parallel zu den ersten Anschlüssen und unter einem Abstand zu den ersten Anschlüssen nebeneinander geradlinig aufgereiht sein.

Das Brückenelement kann eine elektrisch leitende Leiste aufweisen. Die Leiste kann eine Kupferleiste sein oder aus einem anderen elektrisch leitenden metallischen Werkstoff bestehen.

Gemäß einer Ausgestaltung der Schaltvorrichtung kann vorgesehen sein, dass die Leiste unter einem Abstand zu den ersten Anschlüssen und den dritten Anschlüssen angeordnet ist und parallel zur Längsrichtung und zu den geradlinig aufgereihten ersten und dritten Anschlüssen erstreckt ist.

Alternativ oder ergänzend kann vorgesehen sein, dass die ersten Anschlüsse zwischen der Leiste und den dritten Anschlüssen angeordnet sind.

Es kann vorgesehen sein, dass der erste Kontaktblock eine Anschlussseite aufweist im Bereich derer die ersten Anschlüsse mit einem einer zu prüfenden Batterie zugeordneten Kabelbaum verbindbar ist und im Bereich derer die zweiten Anschlüsse mit einem Funktions-Tester verbindbar sind und dass der erste Kontaktblock eine der Anschlussseite abgewandte Umschaltseite aufweist, im Bereich derer der erste Kontaktblock mit dem zweiten Kontaktblock verbindbar ist.

Gemäß einer Ausgestaltung der Schaltvorrichtung kann vorgesehen sein, dass die ersten Anschlüsse und die dritten Anschlüsse ein erstes Steckgesicht ausbilden und dass Anschlüsse des zweiten Kontaktblocks ein zu dem ersten Steckgesicht passendes zweites Steckgesicht ausbilden, so dass die ersten Anschlüsse und die dritten Anschlüsse durch ein Bewegen des zweiten Kontaktblocks in die zweite Kontaktstellung gleichzeitig mittels des zweiten Kontaktblocks miteinander verbindbar sind.

Es kann vorgesehen sein, dass die Anzahl der ersten Anschlüsse und die Anzahl der dritten Anschlüsse identisch sind.

Gemäß einer Ausgestaltung der Schaltvorrichtung kann vorgesehen sein, dass Anschlüsse des zweiten Kontaktblocks vierte Anschlüsse und fünfte Anschlüsse aufweisen, deren Anzahl und Anordnung der Anzahl und Anordnung der ersten Anschlüsse und der dritten Anschlüsse entspricht.

Es kann vorgesehen sein, dass die ersten Anschlüsse, das Brückenelement und die dritten Anschlüsse entlang eines Stellwegs des zweiten Kontaktblocks betrachtet auf gleicher Höhe angeordnet sind.

Gemäß einer Ausgestaltung der Schaltvorrichtung kann vorgesehen sein, dass der zweite Kontaktblock automatisiert verfahrbar ist.

Es kann vorgesehen sein, dass dem zweiten Kontaktblock eine erste Achse zugeordnet ist, um den zweiten Kontaktblock quer zu dem ersten Kontaktblock zu verschieben und dass dem zweiten Kontaktblock eine zweite Achse zugeordnet ist, um den zweiten Kontaktblock zum Herstellen einer Steckverbindung in Richtung des ersten Kontaktblocks und zum Lösen einer Steckverbindung von dem ersten Kontaktblock zu entfernen.

Gemäß einem zweiten Aspekt betrifft die Erfindung einen Prüfstand für elektrische Komponenten zum Prüfen einer Batterie, mit einem Hochvolt-Tester mit einem Funktions-Tester, wobei der Funktionstester eine Quelle und/oder Senke zum Laden und/oder Entladen der Batterie aufweist und/oder wobei der Funktionstester eine Datenschnittstelle und/oder eine 12 Volt Versorgung zum Steuern der Batterie aufweist, mit einer Schaltvorrichtung.

Gemäß einem dritten Aspekt betrifft die Erfindung einen Prüfstand für elektrische Komponenten zum Prüfen einer Batterie, mit einem Hochvolt-Tester mit einem Funktions-Tester, wobei der Funktions-Tester eine Quelle und Senke zum Laden und Entladen der Batterie aufweist und wobei der Funktionstester eine Datenschnittstelle und eine 12 Volt Versorgung zum Steuern der Batterie aufweist mit einer erfindungsgemäßen Schaltvorrichtung, die mit der Quelle und Senke verbunden ist und zur Umschaltung von der Quelle und Senke auf den Hochvolt-Tester vorgesehen ist, mit einer weiteren erfindungsgemäßen Schaltvorrichtung, die mit der Datenschnittstelle und der 12 Volt Versorgung verbunden ist und die zum Umschalten von der Datenschnittstelle und der 12 Volt Versorgung auf den Hochvolt-Tester vorgesehen ist.

Wenn im vorliegenden Text von einem Prüfstand für elektrische Komponenten gesprochen wird, so kann es sich dabei insbesondere um einen Batterieprüfstand handeln.

Nachfolgend wird die Erfindung anhand von Ausführungsbeispiele darstellenden Zeichnungen näher beschrieben. Es zeigen jeweils schematisch:
- Fig. 1: eine erste erfindungsgemäße Schaltvorrichtung für einen Prüfstand für elektrische Komponenten in einer perspektivischen Ansicht;
- Fig. 2: die Schaltvorrichtung aus Fig. 1 in einer Draufsicht;
- Fig. 3: einen ersten Kontaktblock der Schaltvorrichtung aus Fig. 1 in eine Ansicht von unten;
- Fig. 4: einen zweiten Kontaktblock der Schaltvorrichtung aus Fig. 1 in einer Draufsicht mit ausgeblendetem ersten Kontaktblock;
- Fig. 5: die Schaltvorrichtung aus Fig. 1 in einer Seitenansicht mit dem ersten Kontaktblock und dem zweiten Kontaktblock in einem entkoppelten Zustand in einem Teilschnitt;
- Fig. 6: die Schaltvorrichtung aus Fig. 1 in einer Seitenansicht mit dem ersten Kontaktblock und dem zweiten Kontaktblock in einem gekoppelten Zustand in einer ersten Kontaktstellung in einem Teilschnitt;
- Fig. 7: die Schaltvorrichtung aus Fig. 1 in einer Seitenansicht mit dem ersten Kontaktblock und dem zweiten Kontaktblock in einem gekoppelten Zustand in einer zweiten Kontaktstellung in einem Teilschnitt;
- Fig. 8: die Schaltvorrichtung aus Fig. 1 in einer weiteren Seitenansicht mit dem ersten Kontaktblock und dem zweiten Kontaktblock in einem entkoppelten Zustand in einem Teilschnitt;
- Fig. 9: die Schaltvorrichtung aus Fig. 1 in einer weiteren Seitenansicht mit dem ersten Kontaktblock und dem zweiten Kontaktblock in einem gekoppelten Zustand in der zweiten Kontaktstellung in einem Teilschnitt;
- Fig. 10: die Schaltvorrichtung aus Fig. 1 in einer weiteren Seitenansicht mit dem ersten Kontaktblock und dem zweiten Kontaktblock in einem entkoppelten Zustand in einem Teilschnitt;
- Fig. 11: die Schaltvorrichtung aus Fig. 1 in einer weiteren Seitenansicht mit dem ersten Kontaktblock und dem zweiten Kontaktblock in einem gekoppelten Zustand in der ersten Kontaktstellung in einem Teilschnitt;
- Fig. 12: eine zweite erfindungsgemäße Schaltvorrichtung für einen Prüfstand für elektrische Komponenten in einer perspektivischen Ansicht;
- Fig. 13: die Schaltvorrichtung aus Fig. 12 in einer Draufsicht;
- Fig. 14: die Schaltvorrichtung aus Fig. 12 in einer Seitenansicht in einem entkoppelten Zustand in einem Teilschnitt;
- Fig. 15: die Schaltvorrichtung aus Fig. 12 in einer Seitenansicht in einem entkoppelten Zustand in einem Teilschnitt;
- Fig. 16: die Schaltvorrichtung aus Fig. 12 in einer Seitenansicht in einem gekoppelten Zustand in einer ersten Kontaktstellung;
- Fig. 17: die Schaltvorrichtung aus Fig. 12 in einer Seitenansicht in einem gekoppelten Zustand in einer zweiten Kontaktstellung
- Fig. 18: einen erfindungsgemäßen Prüfstand für elektrische Komponenten mit den Schaltvorrichtungen in der zweiten Kontaktstellung;
- Fig. 19: einen erfindungsgemäßen Prüfstand für elektrische Komponenten mit den Schaltvorrichtungen in der ersten Kontaktstellung.

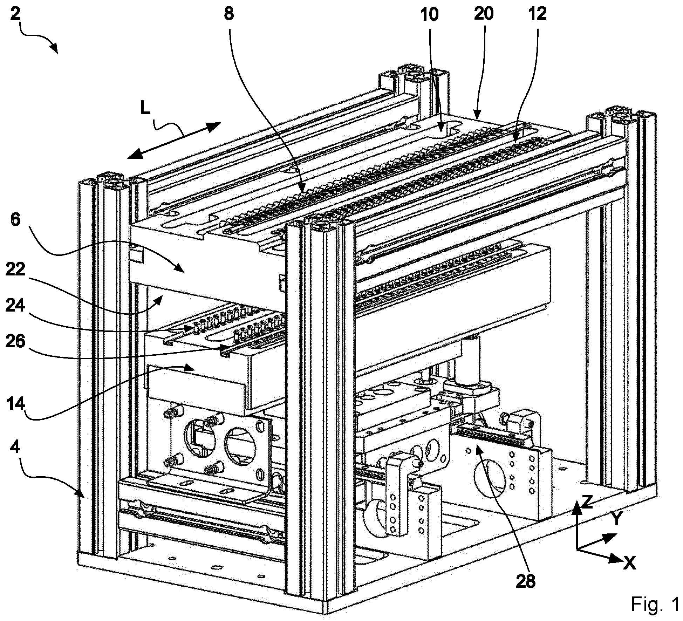

Fig. 1 zeigt eine erste erfindungsgemäße Schaltvorrichtung 2 für einen Prüfstand für elektrische Komponenten in einer perspektivischen Ansicht. Zur besseren Nachvollziehbarkeit der nachstehenden Ausführungen wird ein kartesisches Koordinatensystem X-Y-Z eingeführt.

Die Schaltvorrichtung 2 hat eine Tragstruktur 4. Bei der Tragstruktur 4 handelt es sich vorliegend um eine aus Aluminiumprofilen zusammengesetzte Tragstruktur 4. An der Tragstruktur 4 ist ein erster Kontaktblock 6 befestigt.

Der erste Kontaktblock 6 hat erste Anschlüsse 8 zum Anschließen einer zu prüfenden Batterie. Im vorliegenden Beispiel hat der erste Kontaktblock 6 genau 40 erste Anschlüsse 8 und genau 40 dritte Anschlüsse 12. Die ersten Anschlüsse 8 und die dritten Anschlüsse 12 sind für einen Strom von maximal 32 Ampere und für eine Spannung von maximal 10 kV ausgelegt.

Die ersten Anschlüsse 8 sind nebeneinander entlang einer Längsrichtung (L) geradlinig aufgereiht. Die dritten Anschlüsse 12 sind parallel zu den ersten Anschlüssen 8 und unter einem Abstand zu den ersten Anschlüssen 8 nebeneinander geradlinig aufgereiht.

Der erste Kontaktblock 6 hat vorliegend zwei zweite Anschlüsse 10 zum Anschließen eines Hochvolt-Testers, wobei einer der Anschlüsse 10 einen Signalanschluss und einer der Anschlüsse 10 einen Leistungsanschluss darstellt.

Der erste Kontaktblock 6 hat dritte Anschlüsse 12 zum Anschließen eines Funktions-Testers. Der erste Kontaktblock 6 dient somit dazu, einerseits eine zu prüfende Batterie und andererseits Testeinrichtungen, wie einen Hochvolt-Tester und einen Funktions-Tester, mit der Schaltvorrichtung 2 zu verbinden.

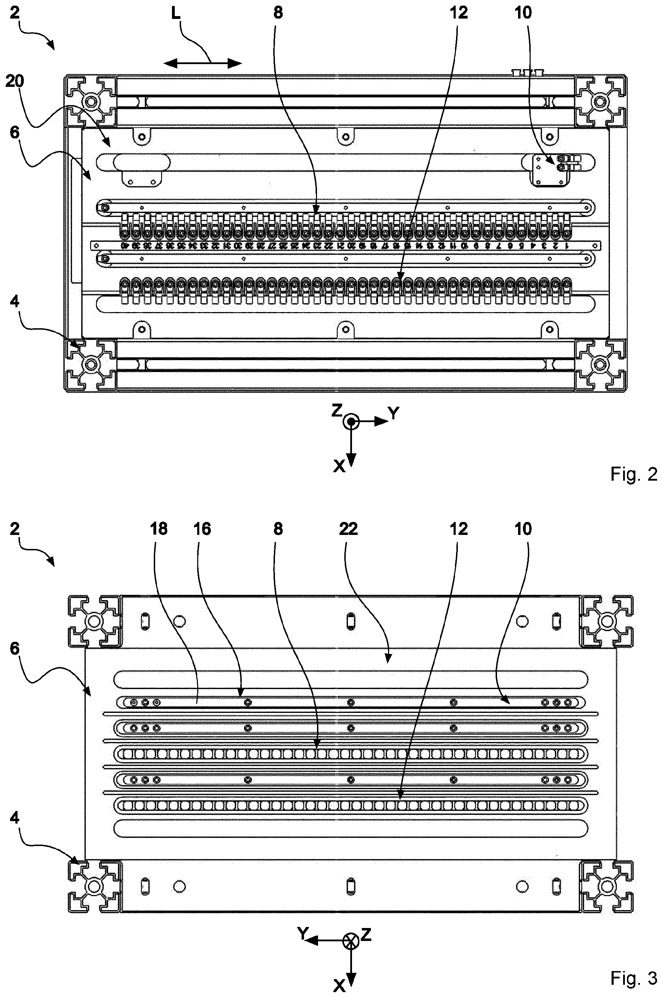

Fig. 2 zeigt den ersten Kontaktblock mit seinen ersten Anschlüssen 8, seinen zweiten Anschlüssen 10 und seinen dritten Anschlüssen 12 in einer Draufsicht.

Im vorliegenden Beispiel ist der erste Kontaktblock 6 feststehend, d. h. unbeweglich an der Tragstruktur 4 gehalten. Der erste Kontaktblock 6 ist demnach nicht relativ zur Tragstruktur 4 bewegbar.

Die Schaltvorrichtung 2 hat einen zweiten Kontaktblock 14. Der zweite Kontaktblock 14 ist eine Kontaktbrücke 14. Der zweite Kontaktblock 14 ist relativ zu dem zweiten Kontaktblock 6 bewegbar.

Die Schaltvorrichtung 2 dient zum Umschalten eines Prüfstand sfür elektrische Komponenten zwischen zwei verschiedenen Betriebsmodi - und zwar einer Leistungsprüfung bzw. Funktionsprüfung und einer Isolationsprüfung.

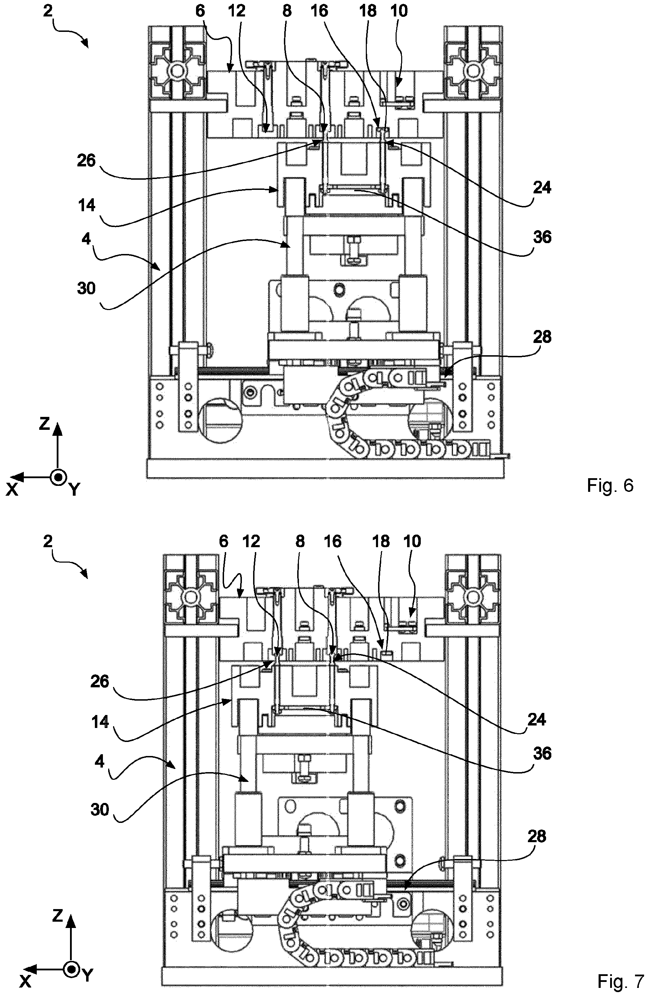

In einer ersten Kontaktstellung verbindet der zweite Kontaktblock 14 die ersten Anschlüsse 8 mit den zweiten Anschlüssen 10. Die erste Kontaktstellung ist in einer Seitenansicht in Fig. 6 gezeigt. In der ersten Kontaktstellung sind die ersten Anschlüsse 8 mittels eines Brückenelements 16 des ersten Kontaktblocks 6 gebrückt und über dieses Brückenelement mit den zweite Anschlüssen 10 verbunden. Das Brückenelement 16 weist hierzu eine elektrisch leitende Leiste 18 auf, die vorliegend eine Kupferleiste ist.

Die Leiste 18 ist unter einem Abstand zu den ersten Anschlüssen 8 und den dritten Anschlüssen 12 angeordnet und ist parallel zur Längsrichtung L und zu den geradlinig aufgereihten ersten Anschlüssen 8 und dritten Anschlüssen 12 erstreckt (Fig. 3). Die ersten Anschlüsse 8 sind zwischen der Leiste 18 und den dritten Anschlüssen 12 angeordnet.

Der zweite Kontaktblock 14 verbindet in einer zweiten Kontaktstellung die ersten Anschlüsse 8 mit den dritten Anschlüssen 12 (Fig. 7).

Der erste Kontaktblock 6 weist eine Anschlussseite 20 auf, im Bereich derer die ersten Anschlüsse 8 mit einem einer zu prüfenden Batterie zugeordneten Kabelbaum verbindbar ist und im Bereich derer die zweiten Anschlüsse 12 mit einem Funktions-Tester verbindbar sind (Fig. 1).

Der erste Kontaktblock 6 weist eine der Anschlussseite 20 abgewandte Umschaltseite 22 auf, im Bereich derer der erste Kontaktblock 6 mit dem zweiten Kontaktblock 14 verbindbar ist.

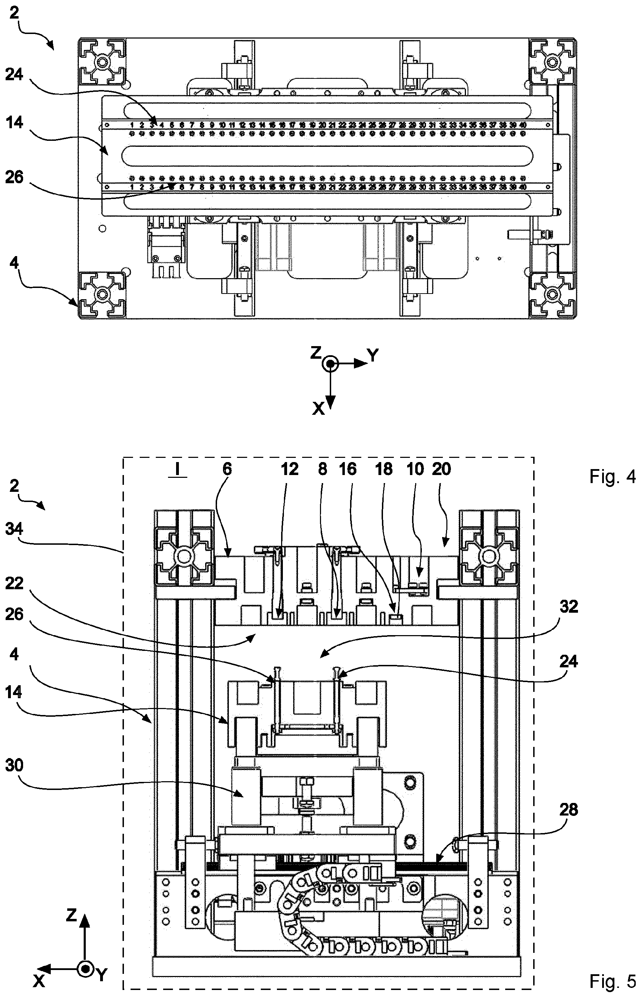

Die ersten Anschlüsse 8 und die dritten Anschlüsse 12 bilden ein erstes Steckgesicht aus (Fig. 3). Anschlüsse 24, 26 des zweiten Kontaktblocks 14 bilden ein zu dem ersten Steckgesicht passendes zweites Steckgesicht aus (Fig. 4).

Die ersten Anschlüsse 8 und die dritten Anschlüsse 12 sind durch ein Bewegen des zweiten Kontaktblocks 14 in die zweite Kontaktstellung gleichzeitig mittels des zweiten Kontaktblocks 14 miteinander verbindbar.

Vorliegend sind die Anzahl der ersten Anschlüsse und die Anzahl der dritten Anschlüsse 12 identisch. Die Anschlüsse 24, 26 des zweiten Kontaktblocks 14 weisen vierte Anschlüsse 24 und fünfte Anschlüsse 26 auf, deren Anzahl und Anordnung der Anzahl und Anordnung der ersten Anschlüsse 8 und der dritten Anschlüsse 12 entspricht. Die Schaltvorrichtung 2 ist vorliegend 40-polig.

Wie Fig. 6 und Fig. 7 zu entnehmen, sind die ersten Anschlüsse 8, das Brückenelement 16 und die dritten Anschlüsse 12 entlang eines Stellwegs (Z-Richtung) des zweiten Kontaktblocks 14 betrachtet auf gleicher Höhe in Z-Richtung angeordnet. Mit dem Erreichen der ersten Kontaktstellung oder der zweiten Kontaktstellung erfolgt daher ein gleichzeitiges Kontaktieren, der in der betreffenden Kontaktstellung einander zugeordneten Anschlüsse.

Der zweite Kontaktblock 14 ist automatisiert verfahrbar ist.

Dem zweiten Kontaktblock 14 ist eine erste Achse 28 zugeordnet ist, um den zweiten Kontaktblock 14 quer zu dem ersten Kontaktblock 6 in X-Richtung zu verschieben.

Dem zweiten Kontaktblock 14 ist eine zweite Achse 30 zugeordnet, um den zweiten Kontaktblock 14 in Z-Richtung zum Herstellen einer Steckverbindung in Richtung des ersten Kontaktblocks 6 zu verschieben und um den zweiten Kontaktblock 14 zum Lösen einer Steckverbindung von dem ersten Kontaktblock 6 zu entfernen.

Nachfolgend wird die Funktionsweise der Schaltvorrichtung 2 beschrieben.

Die Figuren 1, 5, 8, 10 zeigen die Schaltvorrichtung 2 mit dem ersten Kontaktblock 6 und dem zweiten Kontaktblock 14 im entkoppelten Zustand. In diesem entkoppelten Zustand weisen der erste Kontaktblock 6 und der zweite Kontaktblock 14 in Z-Richtung betrachtet einen Abstand zueinander auf, sodass zwischen den Anschlüssen 24, 26 des zweiten Kontaktblocks 14 und den Anschlüssen 8, 10, 12 des ersten Kontaktblocks 6 ein Luftspalt 32 gebildet ist.

Die gesamte Schaltvorrichtung 2 kann von einem Gehäuse 34 umgeben sein, dessen Innenraum I mit einem Überdruck bzw. Sperrluft beaufschlagt wird. So kann die Schaltvorrichtung 2 vor Umgebungseinflüssen, wie Feuchtigkeit, Staub oder Schmutz geschützt werden. Das Gehäuse 34 und der Innenraum I sind lediglich exemplarisch in Figur 5 angedeutet.

Um den zweiten Kontaktblock 14 aus der in Fig. 5 gezeigten Position in die in Figur 6 gezeigte erste Kontaktstellung zu bewegen, wird der zweite Kontaktblock 14 zunächst mit der ersten Achse 28 linear und parallel zur X-Achse gemäß der Anordnung in Fig. 5 nach rechts bewegt, bis sich die Anschlüsse 24, 26 des zweiten Kontaktblocks 14 in vertikaler Z-Richtung betrachtet genau unterhalb der Anschlüsse 8 und der Leiste 18 befinden.

Anschließend wird mittels der zweiten Achse 30 eine lineare Hubbewegung in Z-Richtung ausgeführt, um den zweiten Kontaktblock 14 in Richtung des erste Kontaktblocks 6 zu verschieben und die Anschlüsse 24 elektrisch leitend mit der Leiste 18 zu verbinden und gleichzeitig die Anschlüsse 26 mit den Anschlüssen 8 zu verbinden.

Jeder der jeweiligen Anschlüsse 24 ist mit jeweils einem zugeordneten Anschluss 26 des Kontaktblocks 14 mittels eines jeweiligen Strombalkens 36 verbunden.

In der ersten Kontaktstellung gemäß Fig. 6 ist demnach jeder der ersten Anschlüsse 8 über einen jeweiligen zugeordneten Anschluss 26 und dessen jeweils zugeordneten Strombalken 36 mit einem jeweils zugeordneten Anschluss 24 verbunden, wobei in diesem Fall jeder der Anschlüsse 24 an der Kupferleiste 18 anliegt, um auf diese Weise alle Anschlüsse 8 zu brücken.

Um die Kontaktierung gemäß der ersten Kontaktstellung zu lösen, wird der zweite Kontaktblock 14 mittels der zweiten Achse 30 linear und parallel zur Z Richtung zurückgezogen und von dem ersten Kontaktblock 6 wegbewegt, sodass die Anschlüsse des ersten Kontaktblocks 6 und die Anschlüsse des zweiten Kontaktblocks 14 nicht mehr miteinander im Eingriff sind und der voranstehend beschriebene Luftspalt 32 zwischen den Anschlüssen gebildet ist.

Fig. 7 zeigt die zweite Kontaktstellung. Um den zweiten Kontaktblock 14 aus der in Fig. 5 gezeigten entkoppelten Position in die in Fig. 7 gezeigte kontaktierte Position gemäß der zweiten Kontaktstellung zu bewegen, wird der zweite Kontaktblock 14 ausgehend von der in Fig. 5 gezeigten Position linear und parallel zur Z-Richtung mittels der zweiten Achse 30 in Richtung des ersten Kontaktblocks 6 bewegt.

In der in Fig. 7 gezeigten zweiten Kontaktstellung ist jeder einzelne der Anschlüsse 8 mit einem jeweiligen zugeordneten Anschluss 12 kontaktiert. Hierzu ist jeder der Anschlüsse 8 elektrisch leitend mit einem jeweiligen zugeordneten Anschluss 24 verbunden, wobei der jeweilige zugeordnete Anschluss 24 über einen jeweiligen zugeordneten Strombalken 36 mit einem jeweiligen zugeordneten Anschluss 26 verbunden ist, wobei der jeweilige Anschluss 26 wieder mit einem jeweiligen Anschluss 12 verbunden ist. Jeder der Anschlüsse 8 wird daher einzelnen mit einem jeweiligen zugeordneten Anschluss 12 verbunden, sodass die Anschlüsse 24, 26 mit ihren zugeordneten Strombalken 36, insgesamt 40 einzelne Brückenverbindungen zwischen den Anschlüssen 8, 12 herstellen.

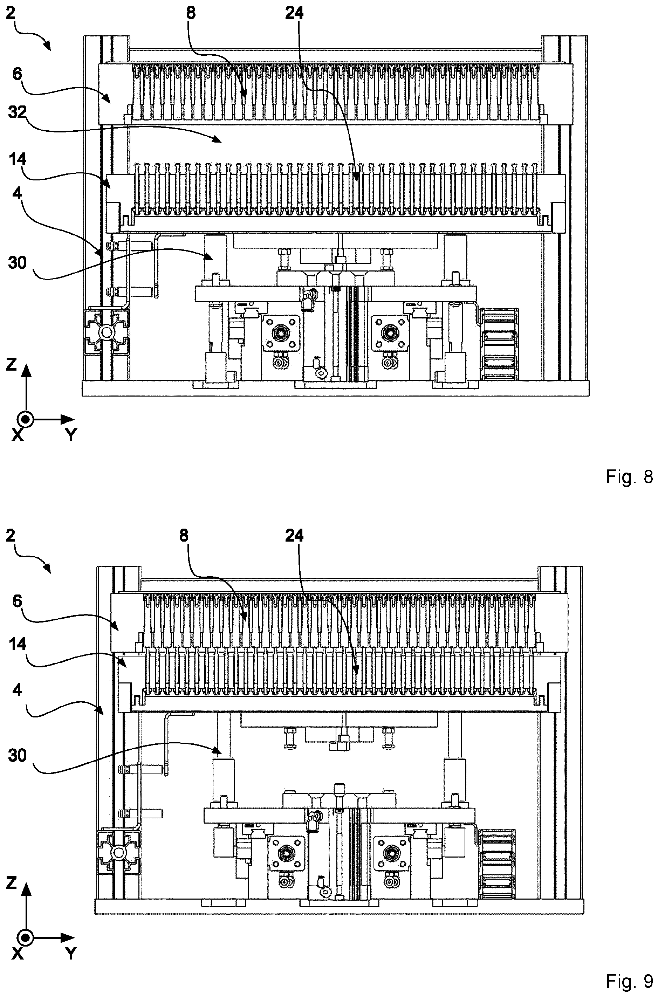

Figur 8 zeigt die Schaltvorrichtung 2 in einer weiteren seitlichen Ansicht vor dem Herstellen einer Kontaktierung gemäß der zweiten Kontaktstellung, wobei Fig. 9 die zweite Kontaktstellung nach dem Ausführen einer Hubbewegung in Z Richtung zeigt.

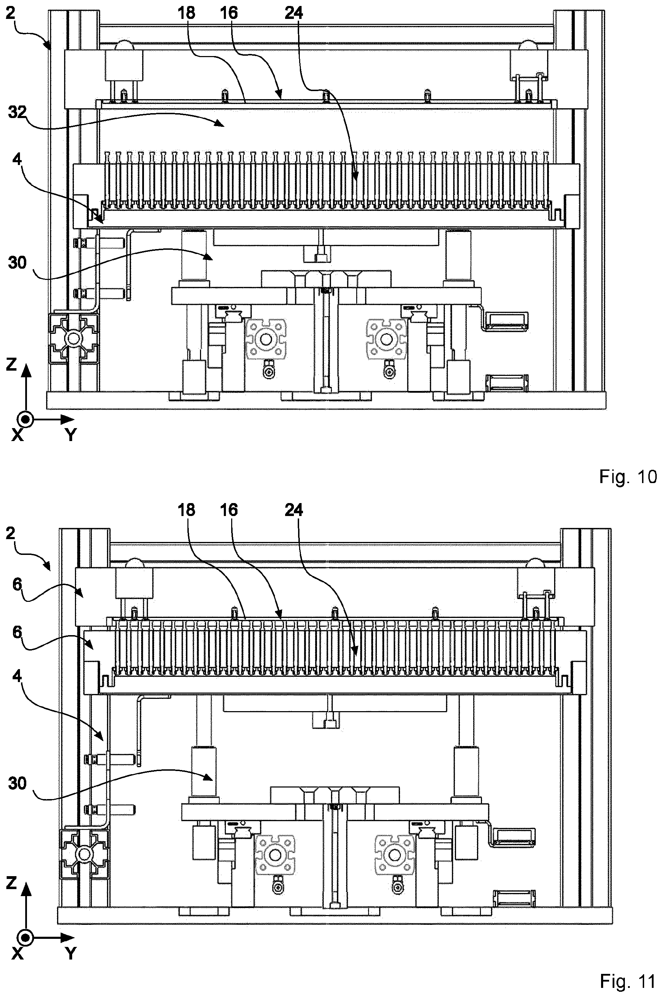

Figur 10 zeigt die Schaltvorrichtung 2 in der weiteren seitlichen Ansicht vor dem Herstellen einer Kontaktierung gemäß der ersten Kontaktstellung, wobei Figur 11 die erste Kontaktstellung nach dem Ausführen einer Hubbewegung in Z Richtung zeigt.

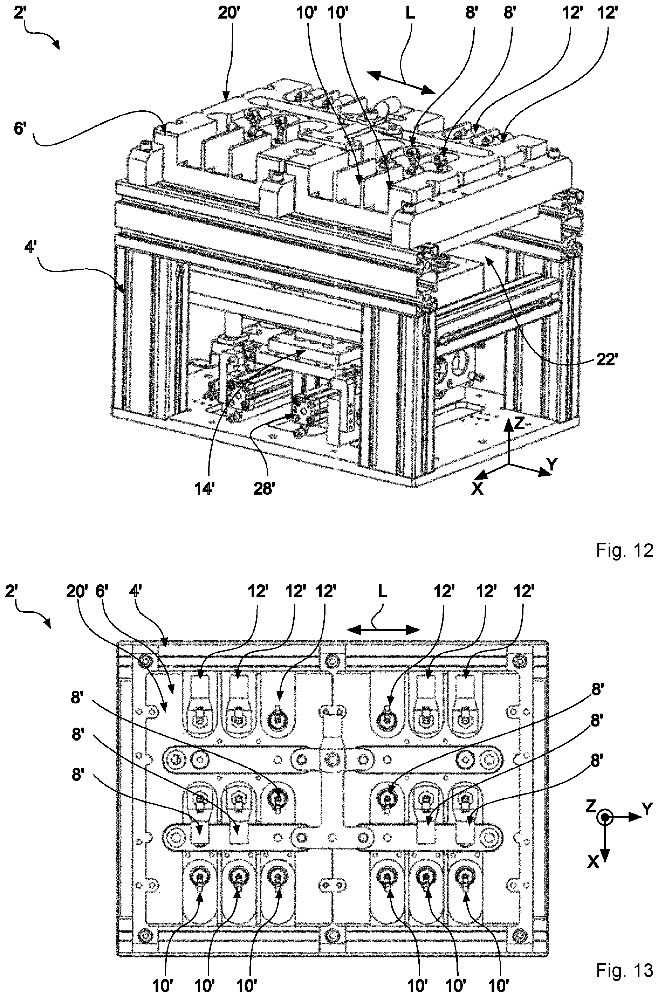

Fig. 12 zeigt eine zweite erfindungsgemäße Schaltvorrichtung 2' für einen Prüfstand für elektrische Komponenten in einer perspektivischen Ansicht. Zur besseren Nachvollziehbarkeit der nachstehenden Ausführungen wird ein kartesisches Koordinatensystem X-Y-Z eingeführt.

Die Schaltvorrichtung 2' hat eine Tragstruktur 4'. Bei der Tragstruktur 4' handelt es sich vorliegend um eine aus Aluminiumprofilen zusammengesetzte Tragstruktur 4'. An der Tragstruktur 4' ist ein erster Kontaktblock 6' befestigt.

Die Schaltvorrichtung 2' ist 6-polig.

Der erste Kontaktblock 6' hat sechs erste Anschlüsse 8' zum Anschließen einer zu prüfenden Batterie. Im vorliegenden Beispiel hat der erste Kontaktblock 6' genau sechs erste Anschlüsse 8' und genau sechs dritte Anschlüsse 12'. Zur besseren Übersichtlichkeit sind in Figur 12 jeweils lediglich zwei der betreffenden Anschlüsse mit einem Bezugszeichen versehen.

Die ersten Anschlüsse 8' und die dritten Anschlüsse 12' sind für einen Strom von maximal 600 Ampere und für eine Spannung von maximal 10 kV ausgelegt.

Die ersten Anschlüsse 8' sind nebeneinander entlang einer Längsrichtung (L) geradlinig aufgereiht. Die dritten Anschlüsse 12' sind parallel zu den ersten Anschlüssen 8' und unter einem Abstand zu den ersten Anschlüssen 8' nebeneinander geradlinig aufgereiht.

Der erste Kontaktblock 6' hat vorliegend sechs zweite Anschlüsse 10' zum Anschließen eines Hochvolt-Testers.

Der erste Kontaktblock 6' hat dritte Anschlüsse 12' zum Anschließen eines Funktions-Testers. Der erste Kontaktblock 6' dient somit dazu, einerseits eine zu prüfende Batterie und andererseits Testeinrichtungen, wie einen Hochvolt-Tester und einen Funktions-Tester, mit der Schaltvorrichtung 2' zu verbinden.

Fig. 2 zeigt den ersten Kontaktblock mit seinen ersten Anschlüssen 8', seinen zweiten Anschlüssen 10' und seinen dritten Anschlüssen 12' in einer Draufsicht.

Im vorliegenden Beispiel ist der erste Kontaktblock 6' feststehend, d. h. unbeweglich an der Tragstruktur 4' gehalten. Der erste Kontaktblock 6' ist demnach nicht relativ zur Tragstruktur 4' bewegbar.

Die Schaltvorrichtung 2' hat einen zweiten Kontaktblock 14'. Der zweite Kontaktblock 14' ist eine Kontaktbrücke 14'. Der zweite Kontaktblock 14' ist relativ zu dem zweiten Kontaktblock 6 bewegbar.

Die Schaltvorrichtung 2' dient zum Umschalten eines Prüfstands für elektrische Komponenten zwischen zwei verschiedenen Betriebsmodi - und zwar einer Leistungsprüfung bzw. Funktionsprüfung und einer Isolationsprüfung.

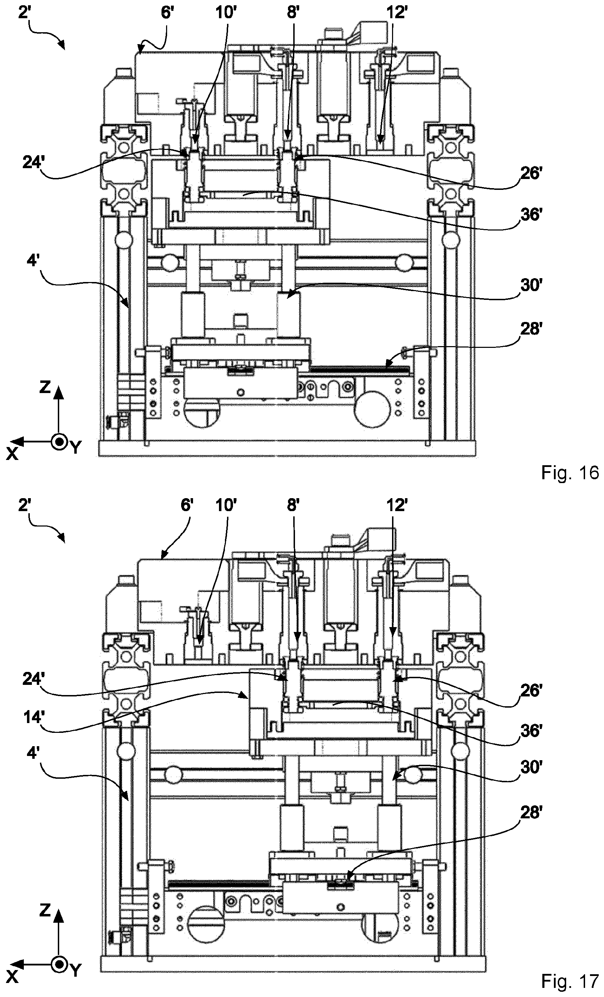

In einer ersten Kontaktstellung verbindet der zweite Kontaktblock 14' die ersten Anschlüsse 8' mit den zweiten Anschlüssen 10'. Die erste Kontaktstellung ist in einer Seitenansicht in Fig. 16 gezeigt.

Der zweite Kontaktblock 14' verbindet in einer zweiten Kontaktstellung die ersten Anschlüsse 8' mit den dritten Anschlüssen 12' (Fig. 17).

Der erste Kontaktblock 6' weist eine Anschlussseite 20' auf, im Bereich derer die ersten Anschlüsse 8' mit einem einer zu prüfenden Batterie zugeordneten Kabelbaum verbindbar ist und im Bereich derer die zweiten Anschlüsse 12' mit einem Funktions-Tester verbindbar sind (Fig. 12).

Der erste Kontaktblock 6' weist eine der Anschlussseite 20' abgewandte Umschaltseite 22' auf, im Bereich derer der erste Kontaktblock 6' mit dem zweiten Kontaktblock 14' verbindbar ist.

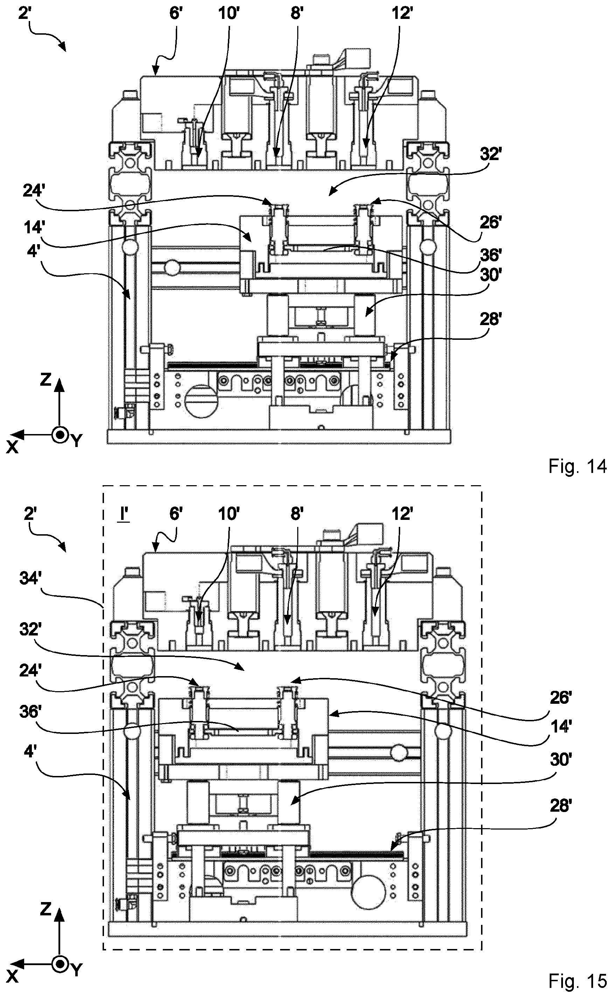

Die ersten Anschlüsse 8' und die dritten Anschlüsse 12' bilden ein erstes Steckgesicht aus. Anschlüsse 24', 26' des zweiten Kontaktblocks 14' bilden ein zu dem ersten Steckgesicht passendes zweites Steckgesicht aus (Fig. 14).

Die ersten Anschlüsse 8' und die dritten Anschlüsse 12' sind durch ein Bewegen des zweiten Kontaktblocks 14' in die zweite Kontaktstellung gleichzeitig mittels des zweiten Kontaktblocks 14' miteinander verbindbar.

Vorliegend sind die Anzahl der ersten Anschlüsse und die Anzahl der dritten Anschlüsse 12' identisch. Die Anschlüsse 24', 26' des zweiten Kontaktblocks 6' weisen vierte Anschlüsse 24' und fünfte Anschlüsse 26' auf, deren Anzahl und Anordnung der Anzahl und Anordnung der ersten Anschlüsse 8', der zweiten Anschlüsse 10' und der dritten Anschlüsse 12' entspricht. Die Schaltvorrichtung 2' ist vorliegend 6-polig.

Wie Fig. 16 und Fig. 17 zu entnehmen, sind die ersten Anschlüsse 8', die zweiten Anschlüsse 10' und die dritten Anschlüsse 12' entlang eines Stellwegs (Z-Richtung) des zweiten Kontaktblocks 14' betrachtet auf gleicher Höhe in Z-Richtung angeordnet. Mit dem Erreichen der ersten Kontaktstellung oder der zweiten Kontaktstellung erfolgt daher ein gleichzeitiges Kontaktieren, der in der betreffenden Kontaktstellung einander zugeordneten Anschlüsse.

Der zweite Kontaktblock 14' ist automatisiert verfahrbar ist.

Dem zweiten Kontaktblock 14' ist eine erste Achse 28' zugeordnet ist, um den zweiten Kontaktblock 14' quer zu dem ersten Kontaktblock 6 in X-Richtung zu verschieben.

Dem zweiten Kontaktblock 14 ist eine zweite Achse 30' zugeordnet, um den zweiten Kontaktblock 14' in Z-Richtung zum Herstellen einer Steckverbindung in Richtung des ersten Kontaktblocks 6' zu verschieben und um den zweiten Kontaktblock 14' zum Lösen einer Steckverbindung von dem ersten Kontaktblock 6' zu entfernen.

Nachfolgend wird die Funktionsweise der Schaltvorrichtung 2' beschrieben.

Die Figuren 14, 15 zeigen die Schaltvorrichtung 2' mit dem ersten Kontaktblock 6' und dem zweiten Kontaktblock 14' im entkoppelten Zustand. In diesem entkoppelten Zustand weisen der erste Kontaktblock 6' und der zweite Kontaktblock 14' in Z-Richtung betrachtet einen Abstand zueinander auf, sodass zwischen den Anschlüssen 24', 26' des zweiten Kontaktblocks 14' und den Anschlüssen 8', 10', 12' des ersten Kontaktblocks 6' ein Luftspalt 32' gebildet ist.

Die gesamte Schaltvorrichtung 2' kann von einem Gehäuse 34' umgeben sein, dessen Innenraum l' mit einem Überdruck bzw. Sperrluft beaufschlagt wird. So kann die Schaltvorrichtung 2' vor Umgebungseinflüssen, wie Feuchtigkeit, Staub oder Schmutz geschützt werden. Das Gehäuse 34' und der Innenraum l' sind lediglich exemplarisch in Figur 15 angedeutet.

Um den zweiten Kontaktblock 14' aus der in Fig. 15 gezeigten Position in die in Fig. 16 gezeigte erste Kontaktstellung zu bewegen, wird mittels der zweiten Achse 30' eine lineare Hubbewegung in Z-Richtung ausgeführt, um den zweiten Kontaktblock 14' in Richtung des erste Kontaktblocks 6' zu verschieben und die Anschlüsse 24' elektrisch leitend mit den Anschlüssen 10' zu verbinden und gleichzeitig die Anschlüsse 26' mit den Anschlüssen 8' zu verbinden.

Jeder der jeweiligen Anschlüsse 24' ist mit jeweils einem zugeordneten Anschluss 26' des Kontaktblocks 14 mittels eines jeweiligen Strombalkens 36' verbunden.

In der ersten Kontaktstellung gemäß Fig. 16 ist demnach jeder der ersten Anschlüsse 8' über einen jeweiligen zugeordneten Anschluss 26' und dessen jeweils zugeordneten Strombalken 36' mit einem jeweils zugeordneten Anschluss 24' verbunden, wobei in diesem Fall jeder der Anschlüsse 24' mit einem jeweiligen Anschluss 10' verbunden ist.

Um die Kontaktierung gemäß der ersten Kontaktstellung zu lösen, wird der zweite Kontaktblock 14' mittels der zweiten Achse 30' linear und parallel zur Z Richtung zurückgezogen und von dem ersten Kontaktblock 6' wegbewegt, sodass die Anschlüsse des ersten Kontaktblocks 6' und die Anschlüsse des zweiten Kontaktblocks 14' nicht mehr miteinander im Eingriff sind und der voranstehend beschriebene Luftspalt 32' zwischen den Anschlüssen gebildet ist.

Fig. 17 zeigt die zweite Kontaktstellung.

Um den zweiten Kontaktblock 14 aus der in Fig. 14 gezeigten entkoppelten Position in die in Fig. 17 gezeigte kontaktierte Position gemäß der zweiten Kontaktstellung zu bewegen, wird der zweite Kontaktblock 14' ausgehend von der in Fig. 14 gezeigten Position linear und parallel zur Z-Richtung mittels der zweiten Achse 30' in Richtung des ersten Kontaktblocks 6 bewegt. Der Kontaktposition ist mittels der ersten Achse 28' in X-Richtung zwischen den Positionen gemäß Fig. 14 und Fig. 15 verfahrbar.

In der in Fig. 17 gezeigten zweiten Kontaktstellung ist jeder einzelne der Anschlüsse 8' mit einem jeweiligen zugeordneten Anschluss 12' kontaktiert. Hierzu ist jeder der Anschlüsse 8' elektrisch leitend mit einem jeweiligen zugeordneten Anschluss 24' verbunden, wobei der jeweilige zugeordnete Anschluss 24' über einen jeweiligen zugeordneten Strombalken 36' mit einem jeweiligen zugeordneten Anschluss 26' verbunden ist, wobei der jeweilige Anschluss 26' wieder mit einem jeweiligen Anschluss 12' verbunden ist. Jeder der Anschlüsse 8' wird daher einzelnen mit einem jeweiligen zugeordneten Anschluss 12' verbunden, sodass die Anschlüsse 24', 26' mit ihren zugeordneten Strombalken 36', insgesamt sechs einzelne Brückenverbindungen zwischen den Anschlüssen 8', 12' herstellen.

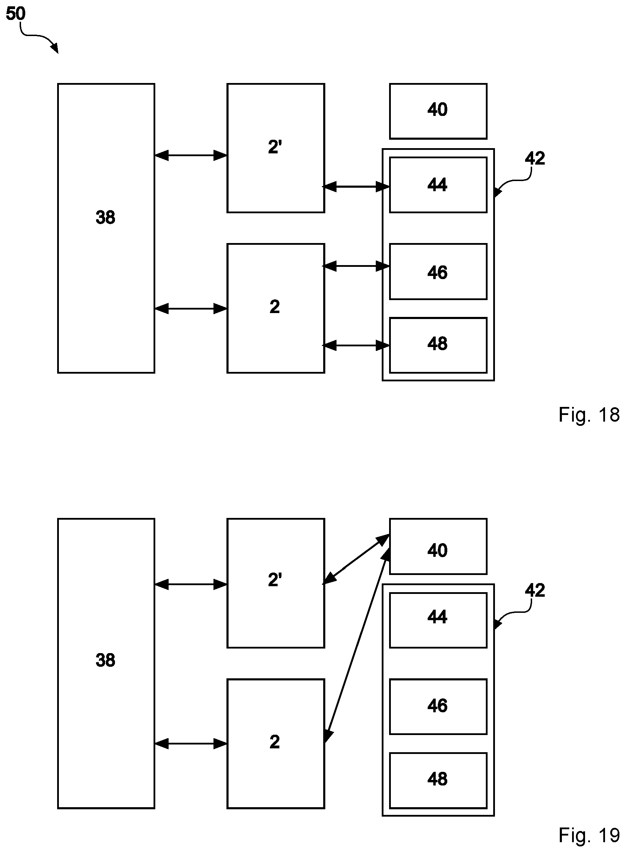

Fig. 18 und Fig. 19 zeigt schematisch einen Prüfstand für elektrische Komponenten 50 zum Prüfen einer Batterie 38. Die Batterie 38 ist eine Traktionsbatterie für ein Kraftfahrzeug.

Der Prüfstand für elektrische Komponenten 50 hat einen Hochvolt-Tester 40.

Der Prüfstand für elektrische Komponenten 50 hat einen einem Funktions-Tester 42, wobei der Funktionstester 42 eine Quelle/Senke 44 zum Laden und Entladen der Batterie 38 aufweist und wobei der Funktionstester 42 eine Datenschnittstelle 46 und eine 12 Volt Versorgung 48 zum Steuern der Batterie 38 aufweist.

Der Prüfstand für elektrische Komponenten 50 hat eine voranstehend beschriebene Schaltvorrichtung 2', die mit der Quelle/Senke 44 verbunden ist und zur Umschaltung von der Quelle/Senke 44 auf den Hochvolt-Tester 40 vorgesehen ist.

Der Prüfstand für elektrische Komponenten 50 hat eine voranstehend beschriebene Schaltvorrichtung 2, die mit der Datenschnittstelle 46 und der 12 Volt Versorgung 48 verbunden ist und die zum Umschalten von der Datenschnittstelle 46 und der 12 Volt Versorgung 48 auf den Hochvolt-Tester 40 vorgesehen ist.

Der Hochvolt-Tester 40 ist dazu eingerichtet, eine Spannung von bis zu 10 Kilovolt bei wenigen Milliampere bereitzustellen.

Die Quelle/Senke ist für eine Lade-/Entladeleistung von 10 - 300 Kilowatt ausgelegt.

Gemäß Fig. 18 befinden sich die Schaltvorrichtungen 2, 2' in der zweiten Kontaktstellung. Der Prüfstand für elektrische Komponenten 50 wird in dem Betriebsmodus "Funktionsprüfung" bzw. "Leistungsprüfung" betrieben, wobei die Batterie 38 mit dem Funktions-Tester 42 und dessen Komponenten 44, 46, 48 verbunden ist.

Gemäß Fig. 19 befinden sich die Schaltvorrichtungen 2, 2' in der ersten Kontaktstellung. Der Prüfstand für elektrische Komponenten 50 wird in dem Betriebsmodus "Isolationsprüfung" betrieben, wobei die Batterie 38 mit dem Hochvolt-Tester 40 verbunden ist.

Der Prüfstand für elektrische Komponenten 50 ist daher mittels der Schaltvorrichtungen 2, 2' zwischen den zwei Betriebsmodi "Funktionsprüfung" und "Isolationsprüfung" umschaltbar.

### Bezugszeichen

- 2, 2': Schaltvorrichtung
- 4, 4': Tragstruktur
- 6, 6': erster Kontaktblock
- 8, 8': erste Anschlüsse
- 10, 10': zweite Anschlüsse
- 12, 12': dritte Anschlüsse
- 14, 14': zweiter Kontaktblock
- 16: Brückenelement
- 18: Leiste
- 20, 20': Anschlussseite
- 22, 22': Umschaltseite
- 24, 24': vierte Anschlüsse
- 26, 26': fünfte Anschlüsse
- 28, 28': erste Achse
- 30, 30': zweite Achse
- 32, 32': Luftspalt
- 34, 34': Gehäuse
- 36, 36': Strombalken
- 38: Batterie
- 40: Hochvolt-Tester
- 42: Funktions-Tester
- 44: Quelle/Senke
- 46: Datenschnittstelle
- 48: 12 Volt Versorgung
- 50: Prüfstand für elektrische Komponenten

## Patentansprüche

1. Schaltvorrichtung für einen Prüfstand für elektrische Komponenten,
- mit einer Tragstruktur (4, 4'),
- mit einem an der Tragstruktur (4, 4') befestigten ersten Kontaktblock (6, 6'),
- wobei der erste Kontaktblock (6, 6') erste Anschlüsse (8, 8') zum Anschließen einer zu prüfenden Batterie aufweist,
- wobei der erste Kontaktblock (6, 6') einen oder mehr zweite Anschlüsse (10, 10') zum Anschließen eines Hochvolt-Testers aufweist und
- wobei der erste Kontaktblock (6, 6') dritte Anschlüsse (12, 12') zum Anschließen eines Funktions-Testers aufweist, **gekennzeichnet durch**
- einen zweiten Kontaktblock (14, 14'),
- wobei der zweite Kontaktblock (14, 14') eine Kontaktbrücke (14, 14') ist
- wobei der zweite Kontaktblock (14, 14') relativ zu dem ersten Kontaktblock (6, 6') bewegbar ist,
- wobei der zweite Kontaktblock (14, 14')
- in einer ersten Kontaktstellung die ersten Anschlüsse (8, 8') mit mindestens einem zweiten Anschluss (10, 10') verbindet, wobei die ersten Anschlüsse (8, 8') in der ersten Kontaktstellung mittels eines Brückenelements (16) des ersten Kontaktblocks (6, 6') gebrückt und über das Brückenelement (16) mit dem mindestens einen zweiten Anschluss (10, 10') verbunden sind
oder
- in einer ersten Kontaktstellung die ersten Anschlüsse (8') mit den zweiten Anschlüssen (10') verbindet,
- wobei der zweite Kontaktblock (14, 14') in einer zweiten Kontaktstellung die ersten Anschlüsse (8, 8') mit den dritten Anschlüssen (12, 12') verbindet.

2. Schaltvorrichtung nach Anspruch 1,
**dadurch gekennzeichnet, dass**
- zwanzig oder mehr erste Anschlüsse (8, 8') und zwanzig oder mehr dritte Anschlüsse (12, 12') vorgesehen sind
und/oder
- einhundert oder weniger erste Anschlüsse (8, 8') und einhundert oder weniger dritte Anschlüsse (12, 12') vorgesehen sind
und/oder
- genau vierzig erste Anschlüsse (8, 8') und genau vierzig dritte Anschlüsse (12, 12') vorgesehen sind.

3. Schaltvorrichtung nach Anspruch 2,
**dadurch gekennzeichnet, dass**
die ersten Anschlüsse (8, 8') und die dritten Anschlüsse (12, 12') für einen Strom von maximal 32 Ampere und/oder für eine Spannung von maximal 10 kV ausgelegt sind.

4. Schaltvorrichtung nach Anspruch 1,
**dadurch gekennzeichnet, dass**
- zwei oder mehr erste Anschlüsse (8, 8') und zwei oder mehr dritte Anschlüsse (12, 12') vorgesehen sind
und/oder
- zehn oder weniger erste Anschlüsse (8, 8') und zehn oder weniger dritte Anschlüsse (12, 12') vorgesehen sind
und/oder
- genau drei erste Anschlüsse (8, 8') und genau drei dritte Anschlüsse (12, 12') vorgesehen sind
und/oder
- genau sechs erste Anschlüsse (8, 8') und genau sechs dritte Anschlüsse (12, 12') vorgesehen sind.

5. Schaltvorrichtung nach Anspruch 4,
**dadurch gekennzeichnet, dass**
die ersten Anschlüsse (8, 8') und die dritten Anschlüsse (12, 12') für einen Strom von maximal 1000 Ampere, insbesondere maximal 600 Ampere, und/oder für eine Spannung von maximal 10 Kilovolt ausgelegt sind.

6. Schaltvorrichtung nach einem der voranstehenden Ansprüche,
**dadurch gekennzeichnet, dass**
- die ersten Anschlüsse (8, 8') nebeneinander entlang einer Längsrichtung (L) geradlinig aufgereiht sind,
- die dritten Anschlüsse (12, 12') parallel zu den ersten Anschlüssen (8, 8') und unter einem Abstand zu den ersten Anschlüssen (8, 8') nebeneinander geradlinig aufgereiht sind
und/oder
das Brückenelement (16) eine elektrisch leitende Leiste (18) aufweist insbesondere, dass die Leiste (18) unter einem Abstand zu den ersten Anschlüssen (8, 8') und den dritten Anschlüssen (12, 12') angeordnet ist und parallel zur Längsrichtung und zu den geradlinig aufgereihten ersten und dritten Anschlüssen (12, 12') erstreckt ist und/oder die ersten Anschlüsse (8, 8') zwischen der Leiste (18) und den dritten Anschlüssen (12, 12') angeordnet sind.

7. Schaltvorrichtung nach einem der voranstehenden Ansprüche,
**dadurch gekennzeichnet,**
- **dass** der erste Kontaktblock (6, 6') eine Anschlussseite (20, 20') aufweist im Bereich derer die ersten Anschlüsse (8, 8') mit einem einer zu prüfenden Batterie zugeordneten Kabelbaum verbindbar ist und im Bereich derer die zweiten Anschlüsse (12, 12') mit einem Funktions-Tester verbindbar sind und
- **dass** der erste Kontaktblock eine der Anschlussseite abgewandte Umschaltseite (22, 22') aufweist, im Bereich derer der erste Kontaktblock (6, 6') mit dem zweiten Kontaktblock (14, 14') verbindbar ist.
und/oder
- **dass** die ersten Anschlüsse (8, 8') und die dritten Anschlüsse (12, 12') ein erstes Steckgesicht ausbilden und
- **dass** Anschlüsse (24, 26) des zweiten Kontaktblocks (14, 14') ein zu dem ersten Steckgesicht passendes zweites Steckgesicht ausbilden
- so dass die ersten Anschlüsse (8, 8') und die dritten Anschlüsse (12, 12') durch ein Bewegen des zweiten Kontaktblocks (14, 14') in die zweiten Kontaktstellung gleichzeitig mittels des zweiten Kontaktblocks (14, 14') miteinander verbindbar sind.

8. Schaltvorrichtung nach einem der voranstehenden Ansprüche,
**dadurch gekennzeichnet,**
**dass** die Anzahl der ersten Anschlüsse (8, 8') und die Anzahl der dritten Anschlüsse (12, 12') identisch sind.

9. Schaltvorrichtung nach Anspruch 8,
**dadurch gekennzeichnet,**
- **dass** Anschlüsse (24, 26) des zweiten Kontaktblocks (6, 6') vierte Anschlüsse (24, 24') und fünfte Anschlüsse (26, 26') aufweisen,
- deren Anzahl und Anordnung der Anzahl und Anordnung der ersten Anschlüsse (8, 8') und der dritten Anschlüsse (12, 12') entspricht.

10. Schaltvorrichtung nach einem der voranstehenden Ansprüche,
**dadurch gekennzeichnet, dass**
- die ersten Anschlüsse (8, 8'), das Brückenelement (16) und die dritten Anschlüsse (12, 12') entlang eines Stellwegs des zweiten Kontaktblocks (14, 14') betrachtet auf gleicher Höhe angeordnet sind.
und/oder
- der zweite Kontaktblock (14, 14') automatisiert verfahrbar ist, insbesondere, dass dem zweiten Kontaktblock (14, 14') eine erste Achse (28, 28') zugeordnet ist, um den zweiten Kontaktblock (14, 14') quer dem ersten Kontaktblock (6, 6') zu verschieben und dass dem zweiten Kontaktblock (14, 14') eine zweite Achse (30, 30') zugeordnet ist, um den um den zweiten Kontaktblock (14, 14') zum Herstellen einer Steckverbindung in Richtung des ersten Kontaktblocks (6, 6') und zum Lösen einer Steckverbindung von dem ersten Kontaktblock (6, 6') zu entfernen.

11. Prüfstand für elektrische Komponenten zum Prüfen einer Batterie,
- mit einem Hochvolt-Tester (40),
- mit einem Funktions-Tester (42),
- wobei der Funktionstester (42) eine Quelle (44) und/oder Senke (44) zum Laden und/oder Entladen der Batterie (38) aufweist und/oder wobei der Funktionstester eine Datenschnittstelle (46) und/oder eine 12 Volt Versorgung (48) zum Steuern der Batterie (38) aufweist
- mit einer Schaltvorrichtung (2, 2') nach einem der voranstehenden Ansprüche.

12. Prüfstand für elektrische Komponenten zum Prüfen einer Batterie,
- mit einem Hochvolt-Tester (40),
- mit einem Funktions-Tester (42),
- wobei der Funktionstester (42) eine Quelle (44) und Senke (44) zum Laden und Entladen der Batterie (38) aufweist und wobei der Funktionstester (42) eine Datenschnittstelle (46) und eine 12 Volt Versorgung (48) zum Steuern der Batterie (38) aufweist
- mit einer Schaltvorrichtung (2') nach einem der Ansprüche 1-10, die mit der Quelle (44) und Senke (44) verbunden ist und zur Umschaltung von der Quelle (44) und Senke (44) auf den Hochvolt-Tester (40) vorgesehen ist,
- mit einer weiteren Schaltvorrichtung (2) nach einem der Ansprüche 1-10, die mit der Datenschnittstelle (46) und der 12 Volt Versorgung (48) verbunden ist und die zum Umschalten von der Datenschnittstelle (48) und der 12 Volt Versorgung (48) auf den Hochvolt-Tester (40) vorgesehen ist.

## Claims

1. Switching device for a test bench for electrical components,
- having a support structure (4, 4'),
- having a first contact block (6, 6') attached to the support structure (4, 4'),
- wherein the first contact block (6, 6') has first terminals (8, 8') for connecting a battery to be tested,
- wherein the first contact block (6, 6') has one or more second terminals (10, 10') for connecting a high-voltage tester, and
- wherein the first contact block (6, 6') has third terminals (12, 12') for connecting a function tester, **characterized by**
- a second contact block (14, 14'),
- wherein the second contact block (14, 14') is a contact bridge (14, 14'),
- wherein the second contact block (14, 14') is movable relative to the first contact block (6, 6'),
- wherein the second contact block (14, 14')
- connects the first terminals (8, 8') to at least one second terminal (10, 10') in a first contact position, wherein the first terminals (8, 8') are bridged in the first contact position by means of a bridge element (16) of the first contact block (6, 6') and are connected to the at least one second terminal (10, 10') via the bridge element (16), or
- connects the first terminals (8') to the second terminals (10') in a first contact position,
- -wherein the second contact block (14, 14') connects the first terminals (8, 8') to the third terminals (12, 12') in a second contact position.

2. Switching device according to claim 1,
**characterized in that**
- twenty or more first terminals (8, 8') and twenty or more third terminals (12, 12') are provided,
and/or
- one hundred or fewer first terminals (8, 8') and one hundred or fewer third terminals (12, 12') are provided,
and/or
- exactly forty first terminals (8, 8') and exactly forty third terminals (12, 12') are provided.

3. Switching device according to claim 2,
**characterized in that**
the first terminals (8, 8') and the third terminals (12, 12') are designed for a current of maximum 32 amps and/or for a voltage of maximum 10 kV.

4. Switching device according to claim 1,
**characterized in that**
- two or more first terminals (8, 8') and two or more third terminals (12, 12') are provided
and/or
- ten or fewer first terminals (8, 8') and ten or fewer third terminals (12, 12') are provided
and/or
- exactly three first terminals (8, 8') and exactly three third terminals (12, 12') are provided.
and/or
- exactly six first terminals (8, 8') and exactly six third terminals (12, 12') are provided.

5. Switching device according to claim 4,
**characterized in that**
the first terminals (8, 8') and the third terminals (12, 12') are designed for a current of at most 1000 amperes, in particular at most 600 amperes, and/or for a voltage of at most 10 kilovolts.

6. Switching device according to one of the preceding claims, **characterized in that**
- the first terminals (8, 8') are arranged in a straight line next to each other along a longitudinal direction (L),
- the third terminals (12, 12') are arranged in a straight line next to each other parallel to the first terminals (8, 8') and at a distance from the first terminals (8, 8'),
and/or
- the bridge element (16) has an electrically conductive strip (18), in particular that the strip (18) is arranged at a distance from the first terminals (8, 8') and the third terminals (12, 12') and extends parallel to the longitudinal direction and to the linearly arranged first and third terminals (12, 12'), and/or the first terminals (8, 8') are arranged between the strip (18) and the third terminals (12, 12').

7. Switching device according to one of the preceding claims,
**characterized**
- **in that** the first contact block (6, 6') has a connection side (20, 20') in the area of which the first terminals (8, 8') can be connected to a cable harness associated with a battery to be tested and in the area of which the second terminals (12, 12') can be connected to a function tester, and
- **in that** the first contact block has a switch side (22, 22') facing away from the connection side, in the area of which the first contact block (6, 6') can be connected to the second contact block (14, 14'),
and/or
- **in that** the first terminals (8, 8') and the third terminals (12, 12') form a first mating face, and
- **in that** terminals (24, 26) of the second contact block (14, 14') form a second mating face matching the first mating face,
- so that the first terminals (8, 8') and the third terminals (12, 12') can be connected to each other simultaneously by means of the second contact block (14, 14') by moving the second contact block (14, 14') into the second contact position.

8. Switching device according to one of the preceding claims,
**characterized in that**
that the number of first terminals (8, 8') and the number of third terminals (12, 12') are identical.

9. Switching device according to claim 8,
**characterized in**
- **that** terminals (24, 26) of the second contact block (6, 6') have fourth terminals (24, 24') and fifth terminals (26, 26'),
- the number and arrangement of which correspond to the number and arrangement of the first terminals (8, 8') and the third terminals (12, 12').

10. Switching device according to one of the preceding claims,
**characterized in that**
- the first terminals (8, 8'), the bridge element (16), and the third terminals (12, 12') are arranged at the same height when viewed along a travel path of the second contact block (14, 14'),
and/or
- the second contact block (14, 14') is automatically movable, in particular that a first axis (28, 28') is assigned to the second contact block (14, 14') in order to move the second contact block (14, 14') transversely to the first contact block (6, 6'), and **in that** a second axis (30, 30') is assigned to the second contact block (14, 14') is assigned a second axis (30, 30') in order to move the second contact block (14, 14') towards the first contact block (6, 6') to establish a plug connection and to move the second contact block (14, 14') away from the first contact block (6, 6') to disconnect the plug connection.

11. Test bench for electrical components for testing a battery,
- having a high-voltage tester (40),
- having a function tester (42),
- wherein the function tester (42) has a source (44) and/or sink (44) for charging and/or discharging the battery (38) and/or wherein the function tester has a data interface (46) and/or a 12-volt supply (48) for controlling the battery (38)
- having a switching device (2, 2') according to one of the preceding claims.

12. Test bench for electrical components for testing a battery,
- having a high-voltage tester (40),
- having a function tester (42),
- wherein the function tester (42) has a source (44) and sink (44) for charging and discharging the battery (38) and wherein the function tester (42) has a data interface (46) and a 12-volt supply (48) for controlling the battery (38)
- having a switching device (2') according to one of claims 1 to 10, which is connected to the source (44) and sink (44) and is provided for switching from the source (44) and sink (44) to the high-voltage tester (40),
- having a further switching device (2) according to one of claims 1 to 10, which is connected to the data interface (46) and the 12-volt supply (48) and which is provided for switching from the data interface (48) and the 12-volt supply (48) to the high-voltage tester (40).

## Revendications

1. Dispositif de commutation pour banc d'essai de composants électriques,
- présentant une structure porteuse (4, 4'),
- présentant un premier bloc de connecteurs (6, 6') fixé à la structure porteuse (4, 4'),
- le premier bloc de connecteurs (6, 6') comprenant des premiers raccords (8, 8') permettant de connecter une batterie à tester,
- le premier bloc de connecteurs (6, 6') comprenant un ou plusieurs deuxièmes raccords (10, 10') permettant de connecter un testeur haute tension, et
- le premier bloc de connecteurs (6, 6') comprenant des troisièmes raccords (12, 12') permettant de connecter un testeur de fonctionnement, **caractérisé par**
- un deuxième bloc de connecteurs (14, 14'),
- le deuxième bloc de connecteurs (14, 14') étant un pont de contact (14, 14'),
- le deuxième bloc de connecteurs (14, 14') étant mobile par rapport au premier bloc de connecteurs (6, 6'),
- le deuxième bloc de connecteurs (14, 14')
- reliant, dans une première position de contact, les premiers raccords (8, 8') à au moins un deuxième raccord (10, 10'), les premiers raccords (8, 8') étant pontés, dans la première position de contact, au moyen d'un élément de pontage (16) du premier bloc de connecteurs (6, 6') et étant reliés via l'élément de pontage (16) aux deuxièmes raccords (10, 10"), au moins au nombre de un,
ou
- reliant, dans une première position de contact, les premiers raccords (8') aux deuxièmes raccords (10'),
- le deuxième bloc de connecteurs (14, 14') reliant, dans une deuxième position de contact, les premiers raccords (8, 8') aux troisièmes raccords (12, 12').

2. Dispositif de commutation selon la revendication 1,
**caractérisé en ce que**
- vingt premiers raccords (8, 8') ou plus et vingt troisièmes raccords (12, 12') ou plus sont prévus
et/ou **en ce que**
- cent premiers raccords (8, 8') ou moins et cent troisièmes raccords (12, 12') ou moins sont prévus
et/ou **en ce que**
- exactement quarante premiers raccords (8, 8') et exactement quarante troisièmes raccords (12, 12') sont prévus.

3. Dispositif de commutation selon la revendication 2, **caractérisé en ce que** les premiers raccords (8, 8') et les troisièmes raccords (12, 12') sont conçus pour une intensité de 32 ampères maximum et/ou pour une tension de 10 kV maximum.

4. Dispositif de commutation selon la revendication 1,
**caractérisé en ce que**
- deux premiers raccords (8, 8') ou plus et deux troisièmes raccords (12, 12') ou plus sont prévus
et/ou **en ce que**
- dix premiers raccords (8, 8') ou moins et dix troisièmes raccords (12, 12') ou moins sont prévus
et/ou **en ce que**
- exactement trois premiers raccords (8, 8') et exactement trois troisièmes raccords (12, 12') sont prévus
et/ou **en ce que**
- exactement six premiers raccords (8, 8') et exactement six troisièmes raccords (12, 12') sont prévus.

5. Dispositif de commutation selon la revendication 4,
**caractérisé en ce que**
les premiers raccords (8, 8') et les troisièmes raccords (12, 12') sont conçus pour une intensité de 1 000 ampères maximum, en particulier de 600 ampères maximum, et/ou pour une tension de 10 kilovolts maximum.

6. Dispositif de commutation selon l'une des revendications précédentes, **caractérisé en ce que**
- les premiers raccords (8, 8') sont montés en ligne droite les uns à côté des autres selon une direction longitudinale (L),
- les troisièmes raccords (12, 12') sont montés en ligne droite les uns à côté des autres parallèlement aux premiers raccords (8, 8') et à distance des premiers raccords (8, 8')
et/ou **en ce que**
l'élément de pontage (16) comporte une baguette électriquement conductrice (18), en particulier **en ce que** la baguette (18) est disposée à une certaine distance des premiers raccords (8, 8') et des troisièmes raccords (12, 12') et s'étend parallèlement à la direction longitudinale et aux premiers et troisièmes raccords (12, 12') montés en ligne droite et/ou **en ce que** les premiers raccords (8, 8') sont disposés entre la baguette (18) et les troisièmes raccords (12, 12').

7. Dispositif de commutation selon l'une des revendications précédentes, **caractérisé en ce que**
- le premier bloc de connecteurs (6, 6') présente une face de connexion (20, 20'), dans la zone de laquelle les premiers raccords (8, 8') peuvent être reliés à un faisceau de câbles associé à une batterie à tester, et dans la zone de laquelle les deuxièmes raccords (12, 12') peuvent être reliés à un testeur de fonctionnement, et **en ce que**
- le premier bloc de connecteurs présente une face de commutation (22, 22') opposée à la face de connexion, dans la zone de laquelle le premier bloc de connecteurs (6, 6') peut être relié au deuxième bloc de connecteurs (14, 14') et/ou **en ce que**
- les premiers raccords (8, 8') et les troisièmes raccords (12, 12') forment un premier modèle d'enfichage, et **en ce que**
- les raccords (24, 26) du deuxième bloc de connecteurs (14, 14') forment un deuxième modèle d'enfichage adapté au premier modèle d'enfichage,
- de sorte que les premiers raccords (8, 8') et les troisièmes raccords (12, 12'), par un déplacement du deuxième bloc de connecteurs (14, 14') dans la deuxième position de contact, peuvent être reliés entre eux simultanément au moyen du deuxième bloc de connecteurs (14, 14').

8. Dispositif de commutation selon l'une des revendications précédentes, **caractérisé en ce que**
le nombre des premiers raccords (8, 8') et le nombre des troisièmes raccords (12, 12') sont identiques.

9. Dispositif de commutation selon la revendication 8,
**caractérisé en ce que**
- les raccords (24, 26) du deuxième bloc de connecteurs (6, 6') comprennent des quatrièmes raccords
(24, 24') et des cinquièmes raccords (26, 26'),
- dont le nombre et la disposition correspondent au nombre et à la disposition des premiers raccords (8, 8') et des troisièmes raccords (12, 12').

10. Dispositif de commutation selon l'une des revendications précédentes, **caractérisé en ce que**
- les premiers raccords (8, 8'), l'élément de pontage (16) et les troisièmes raccords (12, 12') sont disposés à la même hauteur tel que vu le long d'une trajectoire de réglage du deuxième bloc de connecteurs (14, 14')
et/ou **en ce que**
- le deuxième bloc de connecteurs (14, 14') peut être déplacé de manière automatisée, en particulier **en ce qu'**un premier axe (28, 28') est associé au deuxième bloc de connecteurs (14, 14') afin de déplacer le deuxième bloc de connecteurs (14, 14') transversalement par rapport au premier bloc de connecteurs (6, 6'), et **en ce qu'**un deuxième axe (30, 30') est associé au deuxième bloc de connecteurs (14, 14') afin de déplacer le deuxième bloc de connecteurs (14, 14') en direction du premier bloc de connecteurs (6, 6') afin d'établir une connexion, et de l'éloigner du premier bloc de connecteurs (6, 6') afin de supprimer une connexion.

11. Banc d'essai de composants électriques destiné à tester une batterie,
- comprenant un testeur haute tension (40),
- comprenant un testeur de fonctionnement (42),
- le testeur de fonctionnement (42) comprenant une source (44) et/ou une cathode (44) destinée à charger et/ou décharger la batterie (38) et/ou le testeur de fonctionnement comportant une interface de données (46) et/ou une alimentation 12 volts (48) destinée à commander la batterie (38),
- comprenant un dispositif de commutation (2, 2') selon l'une des revendications précédentes .

12. Banc d'essai de composants électriques destiné à tester une batterie,
- comprenant un testeur haute tension (40),
- comprenant un testeur de fonctionnement (42),
- le testeur de fonctionnement (42) comprenant une source (44) et une cathode (44) destinée à charger et décharger la batterie (38), et le testeur de fonctionnement (42) comprenant une interface de données (46) et une alimentation 12 volts (48) destinée à commander la batterie (38) ,
- comprenant un dispositif de commutation (2) selon l'une des revendications 1 à 10 qui est relié à la source (44) et à la cathode (44) et qui est prévu pour commuter la source (44) et la cathode (44) avec le testeur de haute tension (40),
- comprenant un autre dispositif de commutation (2) selon l'une des revendications 1 à 10 qui est relié à l'interface de données (46) et à l'alimentation 12 volts (48) et qui est prévu pour commuter l'interface de données (48) et l'alimentation 12 volts (48) avec le testeur haute tension (40).
